Europäisches Patentamt

European Patent Office

Office européen des brevets

(19)

(11) Veröffentlichungsnummer: **0 336 172**
**A2**

(12) **EUROPÄISCHE PATENTANMELDUNG**

(21) Anmeldenummer: 89104830.8

(51) Int. Cl.⁴: **H01L 29/00**

(22) Anmeldetag: 17.03.89

(30) Priorität: 08.04.88 DE 3811801

(43) Veröffentlichungstag der Anmeldung:
11.10.89 Patentblatt 89/41

(84) Benannte Vertragsstaaten:
**DE FR GB**

(71) Anmelder: **Siemens Aktiengesellschaft**
**Wittelsbacherplatz 2**
**D-8000 München 2(DE)**

(72) Erfinder: **Gold, Alfred, Dr. rer. nat.**
**Leonrodstrasse 38**
**D-8000 München 19(DE)**

(54) **Halbleiter-Bauelement, geeignet als extrem schneller Schalter.**

(57) MITFET als schneller Schalter mit einer quantum-well-Schichtstruktur (8) mit einer dickenbemessenen mittleren Schicht (9) und einer rauhen Grenzfläche (9/10; 19/10) zwischen mittlerer (9, 19) und daran angrenzender Schicht (10).

EP 0 336 172 A2

## Halbleiter-Bauelement, geeignet als extrem schneller Schalter

Die vorliegende Erfindung bezieht sich auf ein Halbleiter-Bauelement mit den Merkmalen des Oberbegriffes des Patentanspruches 1.

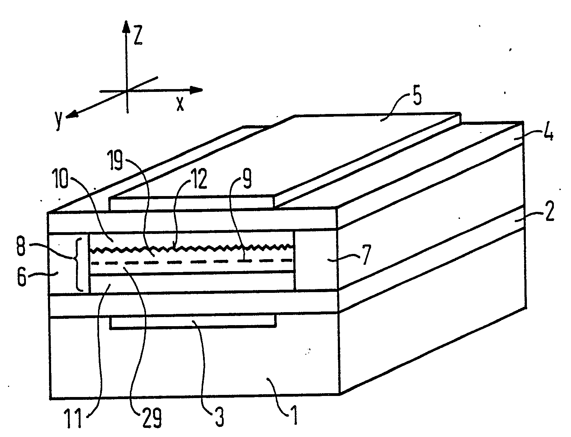

Ein Halbleiter-Bauelement mit den Merkmalen des Oberbegriffes ist aus der Figur 1 in Jap. Journal of Appl. Phys., Bd. 21, (1982), pp. L38I - L383 (L38I) bekannt. Dieses Bauelement hat einen Aufbau nach Art eines Feldeffekttransistors mit Source und Drain und im vorliegenden Falle mit zwei einander gegenüberliegenden Gate-Elektroden. Die Gate-Elektroden sind einander gegenüberliegend parallel zum "Kanal"-Bereich angeordnet und erstrecken sich entsprechend einem normally-on-FET über einen Flächenbereich seitlich des Kanals. Die eine Gate-Elektrode befindet sich außen auf der Oberfläche des Bauelements. Die andere, gegenüberliegende Gate-Elektrode ist innerhalb des Bauelements zwischen Substrat und dem eigentlichen FET-Aufbau angeordnet.

Das aus der obengenannten Figur 1 bekannte Bauelement ist ein Velocity-Modulation-Transistor (VMT). Durch Anlegen elektrischer Spannung an die einander gegenüberliegenden Gate-Elektroden, d.h. durch ein quer zum eigentlichen Kanal gerichtetes elektrisches Feld läßt sich bei diesem Bauelement die Beweglichkeit der im Kanal befindlichen Ladungsträger verändern, mit dem Ergebnis unterschiedlich hohen Source-Drain-Stromes. Bewirkt wird diese Modulation der Beweglichkeit der in der Schichtstruktur des Kanals befindlichen Ladungsträger dadurch, daß das elektrische Modulationsfeld (zwischen den einander gegenüberliegenden Gate-Elektroden) in einer solchen Schichtstruktur wirksam ist, die eine Dicke von 30 nm hat und bei der die mittlere Schicht der Schichtstruktur senkrecht zur Schichtfläche gesehen in zwei aneinander grenzende Schichtanteile mit unterschiedlich hoher Dotierung aufgeteilt ist. Einzelheiten hierzu gehen aus der Figur 2b der obengenannten Druckschrift hervor. Das Einwirken des elektrischen Feldes in dieser hinsichtlich Dotierung ausgebildeten "Doppel"-Schicht läßt eine Steuerung des Source-Drain-Stromes entsprechend einer Modulation dieses elektrischen Feldes zu.

Die maximale Modulationsfrequenz dieses bekannten Bauelementes ist begrenzt durch die Geschwindigkeit, mit der sich eine Änderung der Ladungsträgerbeweglichkeit erzielen läßt. Die Ladungsträgerbeweglichkeit ändert sich mit der Verschiebung der jeweiligen Ladungsträger aus dem Schichtanteil mit der einen Dotierung in den Schichtanteil mit der anderen Dotierung und umgekehrt.

Aus Solid State Communications, Bd. 60 (1986) pp. 531 - 534, insbesondere aus der Figur 2, geht hervor, daß es möglich ist, daß eine Halbleiterschicht in einem Halbleiter-Bauelement das Verhalten entweder eines elektrischen Isolators oder eines Leiters mit praktisch Metall-Leitung hat. Abhängig ist dies für ein derartiges Bauelement davon, ob diese Schicht eine Dicke unterhalb oder eine Dicke oberhalb eines für das Halbleitermaterial der betreffenden Schicht spezifischen Wertes hat. Die Isolatoreigenschaft erhält man dann, wenn diese Schicht eine solche Schichtstruktur ist, die an sich bekannten Quantumwell-Charakter besitzt. Nach Figur 2 dieser Druckschrift ist dies für eine Dicke unterhalb von ca. 30 nm der Fall. In der Erläuterung zu dieser Figur 2 ist der Hinweis enthalten, daß ein punktiert dargestellter Kurvenabschnitt in dieser Figur 2 den Einfluß der Streuung, verursacht durch Oberflächenrauhigkeit, kenntlich macht. Als Maß für in Frage kommende Rauhigkeit sind Zahlenwerte von 0,2 nm (bei einer Schichtdicke von 1 nm). Angegeben sind dort die Verhältnisse für Galliumarsenid und zusätzlich für Indiumarsenid.

Figur 3 dieser Druckschrift zeigt den funktionalen Zusammenhang zwischen Beweglichkeit und Schichtdicke. Kleine Beweglichkeit ($10^2$ cm$^2$/Vs) erhält man bei einer Schichtdicke von 5nm. Beträgt die Schichtdicke z.B. etwa 10 nm, liegt eine um etwa zwei Größenordnungen höhere Beweglichkeit vor.

In IEEE Trans. on El. Dev., Vol. ED 34 (1987), S. 2221 - 2231, sind Studien an InGaAs/InAlAs-Single-quantum-well Quasi-MISFET's beschrieben. Bei diesen Bauelementen bildet eine moduliert-dotierte quantum-well-Struktur den Kanal des MISFET. Undotiertes In-Al-As bildet als semiisolierendes Material for Gate-Isolationsschicht. Bei diesem Bauelement spielt die Dicke der In-Ga-As-Schicht eine große Rolle für die turn-on Charakteristik. Gemessen worden sind dort velocity-field-Charakteristiken des zweidimensionalen Elektronengases im Kanal.

Hohe Ladungsträgerbeweglichkeit wurde in single-quantum-well-Strukturen gemessen, und zwar selbst bei kleinen Dicken von 10 nm der well-Struktur. Die weitere Entwicklung ist dort auf die Verwendung von submicron-Gatelängen gerichtet.

Aufgabe der vorliegenden Erfindung ist es, einen Halbleiter-Schalter mit extrem hoher Schaltgeschwindigkeit anzugeben.

Diese Aufgabe wird durch ein Halbleiter-Bauelement mit den Merkmalen des Anspruches 1 gelöst. Weitere Ausgestaltungen und Weiterbildungen gehen aus den Unteransprüchen hervor.

Die erfindungsgemäße Merkmalskombination des Patentanspruches 1 enthält zwar einzelne Gedanken, die eine gewisse Grundlage in Bemerkungen und Hinweisen der genannten Druckschriften haben. Die Abhängigkeit der Beweglichkeit von der Schichtdicke gemäß der an zweiter Stelle genannten Druckschrift gibt aber keinen Hinweis auf ein technisch brauchbares Bauelement, und insbesondere keinen solchen auf einen schnellen Schalter. Beim Bauelement der erstgenannten Druckschrift erfolgt über Feldstärke abhängige Änderung der Beweglichkeit eine Modulation der Geschwindigkeit der fließenden Ladungsträger. Dieser Effekt ist a priori für sehr schnelle Schalter nur dann verwendbar, wenn extrem kleine Kanallängen vorliegen. Dieses Modulationsprinzip bedingt nämlich, daß zum Erreichen des sperrenden Zustandes des Feldeffekttransistors die Ladungsträger im Kanalbereich ausgeräumt sind. Die endliche Beweglichkeit der Ladungsträger setzt optimal raschem Schalten eine natürliche Grenze entgegen.

Bei der vorliegenden Erfindung wird in Verbindung mit einem speziell für diesen Zweck konzipierten Aufbau mit an diesen Zweck angepaßter Bemessung verwendet, um einen Effekt zu erzielen, der als ein steuerbares Festhalten von Ladungsträgern (mobility modulation) zu bezeichnen ist. Mit der erfindungsgemäß vorgesehenen Steuerspannung zwischen den Gate-Elektroden läßt sich in dem speziellen Aufbau der Erfindung ein Umschalten zwischen zwei Zuständen erreichen, nämlich zwischen einem Zustand mit hoher Beweglichkeit (und entsprechend hohem Source-Drain-Strom der Ladungsträger in der Schichtstruktur) und einem Zustand, bei dem die Beweglichkeit der Ladungsträger in dieser Schichtstruktur blockiert ist.

Die nicht-maßstäbliche Figur zeigt eine prinzipielle Ausführung zur Erfindung.

Auf einem Halbleitersubstrat 1 befindet sich eine erste Gateisolationsschicht 2. Mit 3 ist eine vergrabene Gateelektrode bezeichnet. Mit 4 und 5 sind eine weitere Gateisolationsschicht und eine weitere Gateelektrode angegeben. Source und Drain sind mit 6 und 7 bezeichnet. Die Schichtstruktur 8 umfaßt bei diesem Beispiel eine mittlere Schicht 9 mit der anspruchsgemäßen Dicke d größer 1 nm und kleiner 10 nm und die beiden weiteren Schichten 10 und 11. Eine Quantum-well-Struktur liegt für die erfindungsgemäß bemessene Struktur 9 vor für die folgenden Materialkombinationen:
mittlere Schicht 9 : GaAs, GaAs, InGaAs
weitere Schichten 10, 11: AlAs, AlGaAs, InAlAs.

Mit 12 ist auf die anspruchsgemäße Rauhigkeit Delta 1 der einen Grenzfläche, hier zwischen den Schichten 9 und 10, hingewiesen. Diese Rauhigkeit Delta 1 beträgt z.B. in der Richtung Z z.B. 0,3 nm. Die Rauhigkeit Delta 2 der Grenzfläche zwischen den Schichten 9 und 11 der Struktur 8 soll dagegen möglichst klein sein. Die Rauhigkeit dieser Grenzflächen 9/10 und 9/11 soll in den Richtungen x und y sehr viel größer oder sehr viel kleiner als

$k_F^{-1}$ ( = Fermiwellenlänge) sein.

## Ansprüche

1. Halbleiter-Bauelement mit einem Aufbau nach Art eines Feldeffekttransistors,
mit einem Substratkörper (1),
mit einer darauf befindlichen Schichtstruktur (8) mit wenigstens drei übereinanderliegenden Schichten (9, 10, 11), mit an den einander gegenüberliegenden äußeren Schichtflächen dieser Schichtstruktur vorhandenen Gate-Elektroden (3, 5), wobei sich die eine Gate-Elektrode (3) zwischen dieser Schichtstruktur (8) und derjenigen Oberfläche des Substratkörpers (1) befindet, auf der die Schichtstruktur (8) vorhanden ist, und mit Source- und Drain-Bereichen (6, 7) an gegenüberliegenden Enden der Schichtstruktur (8),
**gekennzeichnet dadurch,**
daß zur Verwendung dieses Halbleiterbauelements als Schalter mit extrem hoher Schaltgeschwindigkeit ($10^{-12}$s) die Schichtstruktur (8) eine mittlere Schicht (9) mit einer Dicke (d) kleiner als 10 nm und größer als 1 nm hat, an deren beiden Flächenseiten je eine weitere Schicht (10, 11) anliegt, daß die Schichtstruktur (8) für die einzelnen Schichten (9, 10, 11) eine Materialkombination aus Halbleitermaterialien aufweist, die bei der vorliegenden Dicke (d) eine Halbleiter-Quantumwellstruktur ergibt und daß die Rauhigkeit (Delta 1) der Grenzfläche (9/10) zwischen der mittleren Schicht (9) und der einen weiteren Schicht (10) unterschiedlich ist von der Rauhigkeit (Delta 2) der Grenzfläche (9/11) zwischen der mittleren Schicht (9) und der anderen weiteren Schicht (11).

2. Halbleiter-Bauelement nach Anspruch 1,
**gekennzeichnet dadurch,**
daß die mittlere Schicht (9) eine Mehrfachschicht mit zwei Einzelschichten (19, 29) ist, wobei der Bandabstand des Materials der einen (19) dieser Einzelschichten verschieden groß verglichen mit dem Bandabstand des Materials der anderen (29) dieser Einzelschichten ist und
daß diejenige Grenzfläche (19, 10) die größere Rauhigkeit (Delta 1) hat, die die Grenzfläche zwischen der Einzelschicht (19) mit dem kleineren Bandabstand und der anliegenden weiteren Schicht (10) ist,
wobei die Schichtdicke der an die Grenzfläche mit der größeren Rauhigkeit (Delta 1) angrenzenden Einzelschicht (19) die wesentliche Dicke ist.